# EUROPEAN PATENT APPLICATION

(11) **EP 4 775 710 A1**
(43) Date of publication of application: **15.07.2026**
(21) Application number: 24861890.2
(22) Date of filing: 30.08.2024
(51) Int. Cl.: C23C 14/35, C23C 14/54

(54) **MAGNETRON SPUTTERING-BASED ADJUSTMENT METHOD, SPUTTERING CATHODE DEVICE, AND SPUTTERING DEVICE**

(30) Priority: 05.09.2023 CN 202311133407
(71) Applicant: Suzhou Maxwell Technologies Co., Ltd., Suzhou, Jiangsu 215200 (CN)
(72) Inventor: XIE, Chuanjia, Suzhou, Jiangsu 215200 (CN); PAN, Junjie, Suzhou, Jiangsu 215200 (CN); ZHAO, Xiangui, Suzhou, Jiangsu 215200 (CN); HANG, Yifeng, Suzhou, Jiangsu 215200 (CN); SHI, Haojie, Suzhou, Jiangsu 215200 (CN)
(74) Representative: Balder IP Law, S.L.
(86) International application number: PCT/CN2024/115691
(87) International publication number: WO 2025/051046

(57) **Abstract**

A magnetron sputtering-based adjustment method, a sputtering cathode device, and a sputtering device. A linear area of an etching track (200) on the surface of each target (1) is divided into a first side track (210) and a second side track (220) which are arranged opposite to each other. The method comprises: acquiring the film thickness distribution condition of a coated substrate subjected to film coating by a corresponding target (1); on the basis of the film thickness distribution condition of the coated substrate, determining which one of the first side track (210) and the second side track (220) is a plasma enhanced side track, and determining which one of the first side track (210) and the second side track (220) is a non-plasma enhanced side track; and integrally weakening the strength of the magnetic field of the plasma enhanced side track.

## Description

This application claims priority to Chinese patent application No.202311133407.7, filed on September 5, 2023. The contents of the above identified applications are hereby incorporated herein in their entireties by reference.

### TECHNICAL FIELD

This application relates to the technical field of vacuum sputtering coating, for example, refers to a magnetron sputtering-based adjustment method, sputtering cathode device, and sputtering device.

### BACKGROUND

Vacuum magnetron sputtering coating is a common coating method. Specifically, it refers to a coating technology in which the coating material is used as a target cathode, argon ions are utilized to bombard the target material to generate cathode sputtering, and target material atoms are sputtered and deposited onto the coating substrate to form a deposition layer.

In related technologies, the cathode device for magnetron sputtering coating usually includes a target material and a magnetron assembly. The magnetron assembly is arranged inside the target material; when the target material rotates in the vacuum chamber, it is sputtered under the combined action of the internal magnetic field and electric field to realize coating of the coating substrate. However, the target material often suffers from non-uniform etching during the etching process, which greatly reduces the utilization rate of the target material. Some related methods generally add an anode assembly at an appropriate position in the vacuum chamber to optimize the distribution of the electric and magnetic fields on the surface of the target material, thereby achieving uniform etching of the target material. Nevertheless, the adjustment of the anode assembly is inflexible and cannot well adapt to different cathode layout conditions. Additionally, a film layer of a certain thickness will deposit on the surface of the anode assembly, resulting in waste of target material and increased costs. Moreover, when the film layer on the surface of the anode assembly accumulates to a certain extent, it is highly likely to peel off; if it falls onto the coating substrate, it is prone to damage the coating substrate and reduce product yield.

### SUMMARY

This application provides a magnetron sputtering-based adjustment method, sputtering cathode device, and sputtering device, which enables uniform etching of the target material, improves the utilization rate of the target material, eliminates the need for additional anode assemblies, reduces costs, and increases product yield.

This application provides a magnetron sputtering-based adjustment method, comprising:
obtaining the film thickness distribution of the coating substrate on which the target material is coated;
judging which one of the first side track and the second side track is the plasma-enhanced side track and which one is the non-plasma-enhanced side track according to the film thickness distribution of the coating substrate; wherein the first side track and the second side track are respectively two oppositely arranged side tracks obtained by dividing the linear region of the etching track on the surface of the target material;
integrally reducing the magnetic field intensity of the plasma-enhanced side track.

In some embodiments, after integrally reducing the magnetic field intensity of the plasma-enhanced side track, the method further includes:
reducing the magnetic field intensity of the first side track and the second side track, wherein the reduction amount of the magnetic field intensity gradually decreases along the direction of the drift current on the etching track; or,
increasing the magnetic field intensity of the first side track and the second side track, wherein the increase amount of the magnetic field intensity gradually decreases along the reverse direction of the drift current on the etching track.

In some embodiments, after reducing the magnetic field intensity of the first side track and the second side track, or increasing the magnetic field intensity of the first side track and the second side track, the method further includes:
after completing the coating process, acquiring the morphology information of the target material in the vacuum chamber;
stopping adjusting the magnetic field intensity in response to the morphology information of the target material meeting the preset requirements; or, returning to execute the step of integrally reducing the magnetic field intensity of the plasma-enhanced side track in response to the morphology information of the target material not meeting the preset requirements.

In some embodiments, acquiring the morphology information of the target material in the vacuum chamber includes:
acquiring the radial dimensions of a plurality of collection points arranged axially on the target material.

In some embodiments, when a plurality of the target materials are arranged at intervals in the vacuum chamber, the plasma-enhanced side track and the plasma-non-enhanced side track on each target material are determined in sequence, and the magnetic field intensity of the plasma-enhanced side track on each target material is integrally reduced in sequence.

The present application also provides a sputtering cathode device, which adopts the above-mentioned adjustment method for magnetron sputtering to regulate the magnetic field intensity at each position of the etching track on the surface of the target material. The sputtering cathode device includes:
a target material, which is rotatably arranged in the vacuum chamber;
a magnetron assembly, which is arranged inside the target material; and
a adjustment assembly, which is configured to regulate the magnetic field intensity at each position of the etching track on the surface of the target material according to the film thickness distribution of the coating substrate.

In some embodiments, the magnetron assembly includes a first yoke, a first magnet array, a second yoke, and a second magnet array. Both the first yoke and the second yoke are disposed inside the target material; the first magnet array is arranged on the first yoke, and the second magnet array is arranged on the second yoke. The first magnet array and the second magnet array are arranged adjacently, and both extend along the axial direction of the target material.

The adjustment assembly includes a first adjustment component and a second adjustment component. The first adjustment component is configured to adjust the distance between each position along the extension direction of the first magnet array and the target material, and the second adjustment component is configured to adjust the distance between each position along the extension direction of the second magnet array and the target material.

In some embodiments, the first adjustment component includes a plurality of first adjustment parts arranged at intervals along the axial direction of the target material. The output end of each first adjustment part is connected to the first yoke, and the output end of the first adjustment part is configured to reciprocate along the radial direction of the target material, so as to drive the part of the first yoke connected to the output end of the first adjustment part to approach or move away from the target material. The second adjustment component includes a plurality of second adjustment part arranged at intervals along the axial direction of the target material. The output end of each second adjustment part is connected to the second yoke, and the output end of the second adjustment part is configured to reciprocate along the radial direction of the target material, so as to drive the part of the second yoke connected to the output end of the second adjustment part to approach or move away from the target material.

In some embodiments, the magnetron assembly further includes a cooling pipe. Both the first yoke and the second yoke are located on one side of the cooling pipe. The first adjustment part is a first adjusting bolt, which is threadedly connected to the cooling pipe and screwed through the cooling pipe to connect with the first yoke.

The second adjustment part is a second adjusting bolt, which is threadedly connected to the cooling pipe and screwed through the cooling pipe to connect with the second yoke.

The present application also provides a sputtering device, including a vacuum chamber, a coating substrates, and the sputtering cathode device as described above. Both the coating substrate and the sputtering cathode device are disposed in the vacuum chamber, and the magnetic field lines generated by the magnetron assembly promote the deposition of atoms sputtered from the target material onto the coating substrate.

### BRIEF DESCRIPTION OF THE DRAWING

FIG. 1 is a schematic structural diagram of an etching track formed on the surface of a target material provided in Embodiment 1 of the present application;
FIG. 2 is Fitting Diagram 1 of the etching rate along the axial direction of the target material surface provided in Embodiment 1 of the present application;
FIG. 3 is Fitting Diagram 2 of the etching rate along the axial direction of the target material surface provided in Embodiment 1 of the present application;
FIG. 4 is a flow chart of the adjustment method for magnetron sputtering provided in Embodiment 1 of the present application;
FIG. 5 is Fitting Diagram 1 of the film thickness distribution of the coating substrate after coating provided in Embodiment 1 of the present application;
FIG. 6 is Fitting Diagram 2 of the film thickness distribution of the coating substrate after coating provided in Embodiment 1 of the present application;
FIG. 7 is a schematic structural diagram of the sputtering cathode device with the target material removed provided in Embodiment 2 of the present application;
FIG. 8 is a cross-sectional structural diagram of the sputtering cathode device with the target material removed provided in Embodiment 2 of the present application.

### Description of elements in the drawings:

200, etching track;
210, first side track;
220, second side track;
1, target material;
2, magnetron assembly;
21, first yoke;
22, first magnet array;
23, second yoke;
24, second magnet array;
25, cooling pipe;
3, adjustment assembly;
31, first adjustment component;
311, first adjustment part;
32, second adjustment component;
321, second adjustment part.

### DETAILED DESCRIPTION OF THE EMBODIMENTS

In the description of this application, unless otherwise explicitly specified and limited, the terms "connected", "coupled", and "fixed" shall be understood in a broad sense. For example, they may refer to a fixed connection, a detachable connection, or integration into a single body; they may refer to a mechanical connection or an electrical connection; they may refer to a direct connection or an indirect connection via an intermediate medium, and may refer to the internal communication between two elements or the interaction relationship between two elements. For those of ordinary skill in the art, the specific meanings of the above terms in this application can be understood according to specific circumstances.

In this application, unless otherwise explicitly specified and limited, a first feature being "on" or "under" a second feature may include the first and second features being in direct contact, or may include the first and second features not being in direct contact but being in contact via another feature therebetween. Furthermore, a first feature being "on", "above", and "over" a second feature includes the first feature being directly above and obliquely above the second feature, or merely indicates that the horizontal height of the first feature is higher than that of the second feature. A first feature being "under", "below", and "beneath" a second feature includes the first feature being directly below and obliquely below the second feature, or merely indicates that the horizontal height of the first feature is lower than that of the second feature.

In the description of this embodiment, terms such as "upper", "lower", "left", and "right" indicating orientation or positional relationship are based on the orientation or positional relationship shown in the accompanying drawings, and are merely for the convenience of description and simplification of operation, rather than indicating or implying that the referred device or element must have a specific orientation, or be constructed and operated in a specific orientation. In addition, the terms "first" and "second" are merely used for differentiation in description and have no special meanings.

### Embodiment 1

In the practical application of vacuum magnetron sputtering coating, for example, in a single-target application scenario, the target material is prone to being affected by the enhancement effect of the vacuum chamber (grounded anode), leading to non-uniform etching of the target material. In a dual-target application scenario, the target material is susceptible to the enhancement effect of adjacent target materials and also to the magnetic field enhancement effect of the vacuum chamber, which also results in non-uniform etching of the target material.

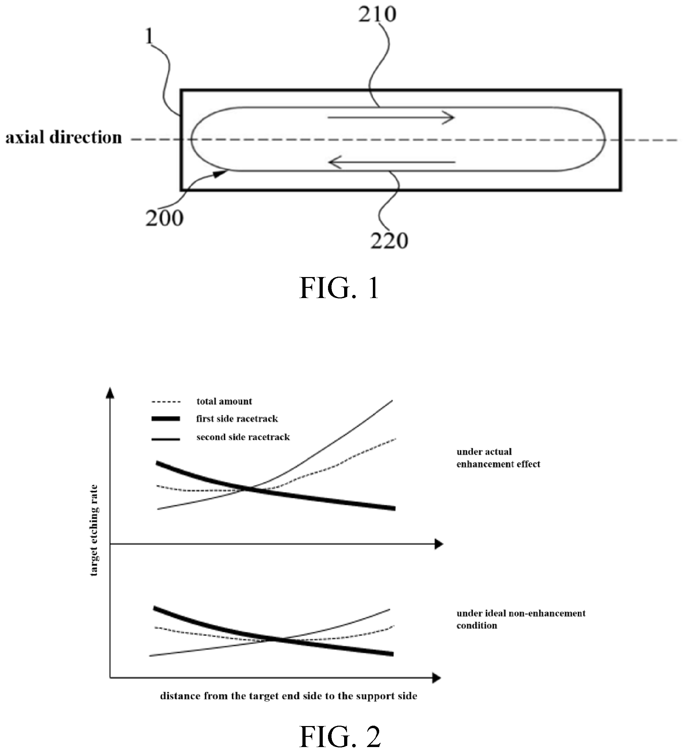

As shown in FIG. 1, during the vacuum magnetron sputtering coating process, when the target material 1 rotates in the vacuum chamber, an etching track 200 is formed on the surface of the target material 1 under the combined action of the internal magnetic field and electric field. The etching track 200 extends along the axial direction of the target material 1 (i.e., from the end side of the target material 1 to the support side of the target material 1). The linear region of the etching track 200 can be divided into a first side track 210 and a second side track 220 arranged oppositely, and drift current circulates along the etching track 200. On the etching track 200, the side where the drift current flows from the end side of the target material 1 to the support side is defined as the first side track 210, and the side where the drift current flows from the support side of the target material 1 to the end side is defined as the second side track 220. It should be noted that the higher the plasma density in a region on the etching track 200, the faster the etching rate at the corresponding region of the target material 1.

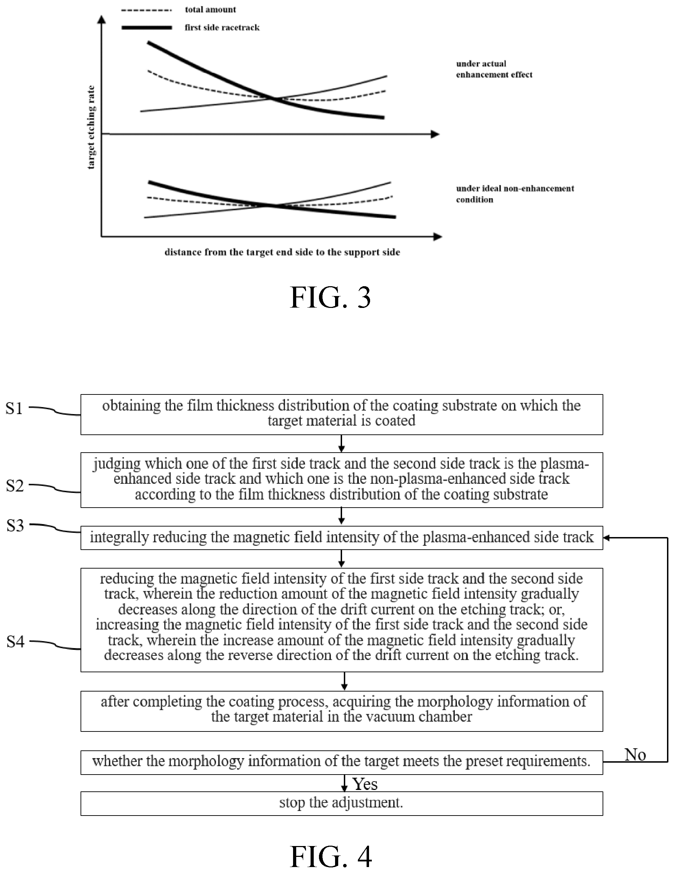

As shown in FIG. 2, experimental verification and analysis have confirmed that there is a non-uniform phenomenon where plasma density gradually decreases along the direction of the drift current on the etching track 200. Additionally, if one side track of the etching track 200 (the second side track 220 is taken as an example in FIG. 2) is affected by a strong enhancement effect from an adjacent target material 1 or the outer anode, the plasma density on this side track will increase. Moreover, due to the existence of the drift current phenomenon, plasma in the enhanced region will be preferentially drawn to regions with higher plasma density, which exacerbates the inhomogeneity along the drift current direction. In contrast, even if the other side track (i.e., the first side track 210 shown in FIG. 2) is affected by the enhancement effect of an adjacent target material 1 or the outer anode, the enhancement effect is relatively weak compared to the strong enhancement effect. Since the etching of the rotating target material 1 is the sum of the etching amounts of the first side track 210 and the second side track 220, the superposition of the etching results on both sides leads to non-uniform etching at the two axial ends of the target material 1. As shown in FIG. 2, under ideal conditions without enhancement, the combined etching amount of the first side track 210 and the second side track 220 is relatively uniform along the axial direction of the target material. Under the influence of actual enhancement effects, the target material 1 often suffers from non-uniform etching during the etching process, which greatly reduces the utilization rate of the target material 1. Furthermore, if the first side track 210 is affected by a strong enhancement effect from an adjacent target material 1 or the outer anode, the result is as shown in FIG. 3. As shown in FIG. 4, this embodiment provides a magnetron sputtering-based adjustment method, where the linear region of the etching track 200 on the surface of the target material 1 is divided into a first side track 210 and a second side track 220 arranged oppositely. The magnetron sputtering-based adjustment method includes:
S1: Obtaining the film thickness distribution of the coating substrate on which the target material 1 is coated;
S2: Judging which one of the first side track 210 and the second side track 220 is the plasma-enhanced side track and which one is the non-plasma-enhanced side track according to the film thickness distribution of the coating substrate;
S3: Integrally reducing the magnetic field intensity of the plasma-enhanced side track.

Here, a side track being a non-plasma-enhanced side track does not mean that there is no plasma enhancement on this side track. In the vacuum chamber, the non-plasma-enhanced side track is also affected by the enhancement effect of the vacuum chamber (grounded anode) and/or adjacent target materials, but compared with the side track with high plasma enhancement intensity, its plasma enhancement intensity is relatively weak, and thus the impact of this side track on the etching uniformity of the target material is also relatively weak.

The adjustment method for magnetron sputtering provided in this embodiment integrally reduces the magnetic field intensity of the plasma-enhanced side track, thereby weakening the impact of the enhancement effect on the plasma density on the first side track 210 or the second side track 220, enabling uniform etching of the target material 1 and improving the utilization rate of the target material 1. In addition, this method eliminates the need for additional anode assemblies, reduces costs, and increases product yield.

The higher the plasma density in a certain region on the etching track 200 of the target material 1, the faster the etching rate of the corresponding region of the target material 1; correspondingly, the film layer on the coating substrate opposite to the region of the target material 1 with a fast etching rate is relatively thicker, resulting in an non-uniform film layer on the coating substrate. Therefore, based on the obtained film thickness distribution of the coating substrate and the known flow direction of the drift current, it can be determined which one of the first side track 210 and the second side track 220 is the plasma-enhanced side track and which one is the non-plasma-enhanced side track. In addition, adjusting the magnetic field intensity on the etching track 200 according to the film thickness distribution of the coating substrate is more accurate, and can also realize the adjustment of the magnetic field intensity earlier and faster. There is no need to wait for the etching morphology of the target material 1 to form before adjustment, which is more proactive.

Optionally, in this embodiment, due to the phenomenon of non-uniform plasma distribution along the direction of the drift current, even without the enhancement effect, there is a certain degree of non-uniformity where the etching amount on both sides of the target material is greater than that in the middle. After step S3, the adjustment method for magnetron sputtering further includes:
S4: Reducing the magnetic field intensity of the first side track 210 and the second side track 220, where the reduction amount of the magnetic field intensity gradually decreases along the direction of the drift current on the etching track 200; or, increasing the magnetic field intensity of the first side track 210 and the second side track 220, where the increase amount of the magnetic field intensity gradually decreases along the reverse direction of the drift current on the etching track 200.

The above adjustment method ensures the uniformity of plasma density at each position on the etching track 200, thereby ensuring uniform etching of the target material 1.

Optionally, in this embodiment, as shown in FIG. 4, after step S4, the magnetron sputtering-based adjustment method further includes:
After completing the coating process, acquiring the morphology information of the target material 1 in the vacuum chamber;
When the morphology information of the target material 1 meets the preset requirements, the adjustment of the magnetic field intensity is stopped;
When the morphology information of the target material 1 does not meet the preset requirements, steps S3 to S4 are repeated.

The above design ensures that the magnetic field intensity at each position on the etching track 200 is adjusted and revised step by step according to the etched morphology of the target material 1 until the target material 1 is uniformly etched.

In other embodiments, when the morphology information of the target material 1 does not meet the preset requirements, only step S3 may be repeated.

In some embodiments, acquiring the morphology information of the target material 1 in the vacuum chamber includes:
Acquiring the radial dimensions of a plurality of collection points arranged axially on the target material 1, i.e., acquire the diameter of the target material 1 at each collection point.

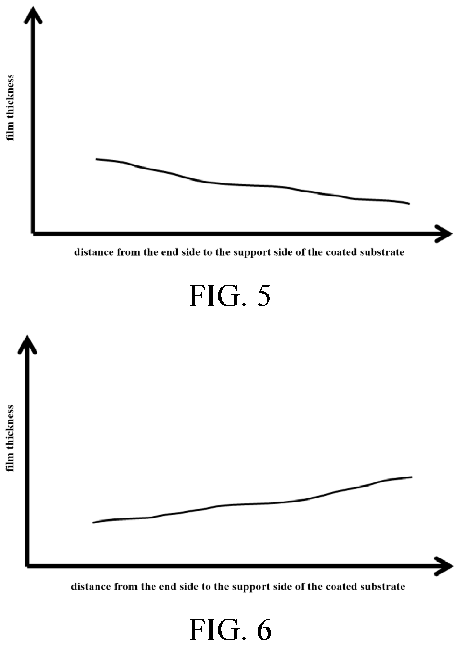

Exemplarily, for a vacuum chamber with a single target material, as shown in FIG. 5, when the film thickness distribution of the coating substrate is as shown in FIG. 5 (i.e., the film layer at the position of the coating substrate opposite to the end side of the target material 1 is thicker), it indicates that the etching rate at the end side of the target material 1 is faster. It can be seen that the distribution trend of the film thickness of the coating substrate is consistent with the flow direction of the drift current in the first side track 210, so it can be inferred that the first side track 210 is the plasma-enhanced side track and the second side track 220 is the non-plasma-enhanced side track. When the film thickness distribution of the coating substrate is as shown in FIG. 6 (i.e., the film layer at the position of the coating substrate opposite to the support side of the target material 1 is thicker), it indicates that the etching rate at the support side of the target material 1 is faster. It can be seen that the distribution trend of the film thickness of the coating substrate is consistent with the drift current distribution in the second side track 220, so it can be inferred that the second side track 220 is the plasma-enhanced side track and the first side track 210 is the non-plasma-enhanced side track.

When a plurality of target materials 1 are arranged at intervals in the vacuum chamber, determine the plasma-enhanced side track and the non-plasma-enhanced side track on each target material 1 in sequence, and adjust the magnetic field intensity of the etching track 200 on the surface of each target material 1 by performing step S3 or steps S3 to S4 in sequence. Exemplarily, when analyzing the plasma-enhanced side track and the non-plasma-enhanced side track of the etching track 200 on one of the target materials 1, the power of the remaining target materials 1 can be reduced to 1/10 or less of the power of the target material 1 to be analyzed. Thus, the film thickness distribution of the coating substrate is mainly caused by the sputtering of the target material 1 to be analyzed, enabling more accurate acquisition of the plasma-enhanced side track and the non-plasma-enhanced side track on the target material 1. When analyzing one of the target materials 1, the power of the remaining target materials 1 is only 1/10 or less of that of the target material 1 to be analyzed. The film thickness contributed by the remaining target materials 1 has little impact on the film thickness distribution of the target material 1 to be analyzed, but can still produce a plasma enhancement effect on the target material 1 to be analyzed. Therefore, this method can actually analyze the actual etching distribution of the target material 1 to be analyzed.

### Embodiment 2

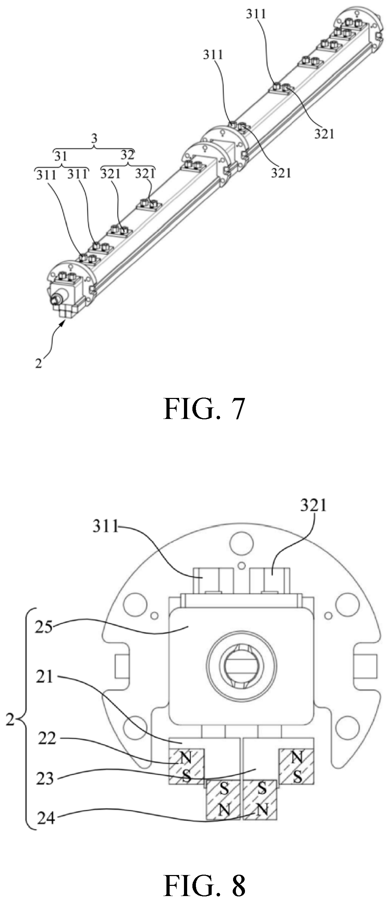

As shown in FIG. 7, this embodiment also provides a sputtering cathode device, which adopts the above-mentioned adjustment method for magnetron sputtering to adjust the magnetic field intensity at each position of the etching track 200 on the surface of the target material 1. The sputtering cathode device provided in this embodiment includes a target material 1, a magnetron assembly 2, and a adjustment assembly 3. Among them, the target material 1 is rotatably arranged in the vacuum chamber, the magnetron assembly 2 is arranged inside the target material 1, and the adjustment assembly 3 is configured to adjust the magnetic field intensity at each position of the etching track 200 on the surface of the target material 1 according to the film thickness distribution of the coating substrate. In some embodiments, the adjustment assembly 3 is arranged inside the target material 1 and the end of the adjustment assembly 3 is connected to the magnetron assembly 2. By applying the above-mentioned adjustment method for magnetron sputtering, the sputtering cathode device provided in this embodiment enables uniform etching of the target material 1, improves the utilization rate of the target material 1, eliminates the need for additional anode assemblies, reduces costs, and increases product yield.

As shown in FIG. 7 and FIG. 8, the magnetron assembly 2 includes a first yoke 21, a first magnet array 22, a second yoke 23, and a second magnet array 24. Both the first yoke 21 and the second yoke 23 are disposed inside the target material 1; the first magnet array 22 is arranged on the first yoke 21, and the second magnet array 24 is arranged on the second yoke 23, with the first magnet array 22 and the second magnet array 24 arranged adjacently. The adjustment assembly 3 includes a first adjustment component 31 and a second adjustment component 32. The first adjustment component 31 is configured to adjust the distance between each position along the extension direction of the first magnet array 22 and the target material 1, and the second adjustment component 32 is configured to adjust the distance between each position along the extension direction of the second magnet array 24 and the target material 1.

In this embodiment, as shown in FIG. 7 and FIG. 8, the first adjustment component 31 includes a plurality of first adjustment parts 311 arranged at intervals along the axial direction of the target material 1. The output end of each first adjustment part 311 is connected to the first yoke 21, and the output end of the first adjustment part 311 can reciprocate along the radial direction of the target material 1 to drive the part of the first yoke 21 connected to the output end of the first adjustment part 311 to approach or move away from the target material 1. The second adjustment component 32 includes a plurality of second adjustment part 321 arranged at intervals along the axial direction of the target material 1. The output end of each second adjustment part 321 is connected to the second yoke 23, and the output end of the second adjustment part 321 can reciprocate along the radial direction of the target material 1 to drive the part of the second yoke 23 connected to the output end of the second adjustment part 321 to approach or move away from the target material 1. It should be noted that under the action of the first magnet array 22 and the second magnet array 24, an etching track 200 is formed on the surface of the target material 1; the first side track 210 is arranged opposite to one of the first magnet array 22 and the second magnet array 24, and the second side track 220 is arranged opposite to the other one of the first magnet array 22 and the second magnet array 24. When it is necessary to integrally reduce the magnetic field intensity of the first side track 210, the magnet array opposite to the first side track 210 is integrally adjusted to move away from the target material 1 by adjusting the first adjustment component 31, for example, the magnet array can be moved 1.5 mm away from the target material 1 as a whole to avoid over-adjustment. When it is necessary to integrally increase the magnetic field intensity of the first side track 210, the magnet array opposite to the first side track 210 is integrally adjusted to move closer to the target material 1 by the adjustment assembly 3, for example, the magnet array can be moved 1.5 mm closer to the target material 1 as a whole to avoid over-adjustment. In addition, the operations for integrally reducing and increasing the magnetic field intensity of the second side track 220 are consistent with those for the first side track 210, and only the distance between the corresponding magnet array and the target material 1 needs to be adjusted.

Furthermore, both the first yoke 21 and the second yoke 23 are made of soft materials; the first magnet array 22 is composed of a plurality of independent magnetic blocks arranged sequentially along the axial direction of the target material 1, and the second magnet array 24 is also composed of a plurality of independent magnetic blocks arranged sequentially along the axial direction of the target material 1. When reducing the magnetic field intensity of the first side track 210 and the second side track 220 with the reduction amount gradually decreasing along the direction of the drift current on the etching track 200, the distance between each independent magnetic block in the magnet array corresponding to the track and the target material 1 is adjusted by the corresponding adjustment component. Similarly, when increasing the magnetic field intensity of the first side track 210 and the second side track 220 with the increase amount gradually decreasing along the reverse direction of the drift current on the etching track 200, the distance between each independent magnetic block in the magnet array corresponding to the track and the target material 1 is also adjusted by the corresponding adjustment component. It is only necessary to ensure that the magnetic blocks corresponding to areas where the magnetic field needs to be increased are adjusted to move closer to the target material 1, and the magnetic blocks corresponding to areas where the magnetic field needs to be decreased are adjusted to move away from the target material 1. Since the magnet arrays are composed of multiple independent magnetic blocks and the yokes are made of soft materials, the reliability of adjusting the distance between each adjustment point along the axial direction of the magnet array and the target material 1 is ensured. Each position where the first adjustment part 311 and the second adjustment part 321 are provided serves as an adjustment point.

In this embodiment, the magnetron assembly 2 further includes a cooling pipe 25, in which a cooling water channel is provided. The cooling water channel is configured to form a circulating water path inside the target material 1 to cool the magnetron assembly 2 and the target material 1. Both the first yoke 21 and the second yoke 23 are located on one side of the cooling pipe 25. The first adjustment part 311 is a first adjusting bolt, which is threadedly connected to the cooling pipe 25 and screwed through the cooling pipe 25 to connect with the first yoke 21. The second adjustment part 321 is a second adjusting bolt, which is threadedly connected to the cooling pipe 25 and screwed through the cooling pipe 25 to connect with the second yoke 23. By designing the adjustment parts as adjusting bolts, the adjustment of the magnetic blocks at the corresponding positions along the radial direction of the target material 1 can be achieved by manually screwing the adjusting bolts, resulting in a simple structure, low cost, and convenient adjustment operations. In this embodiment, since manual screwing of the adjusting bolts is required for adjustment, the vacuum chamber needs to be broken (vacuum released) before performing manual adjustment operations.

In this embodiment, the sputtering cathode device further includes a detection component, which is configured to detect the film thickness distribution of the coating substrate to facilitate the operator in acquiring the film thickness distribution of the coating substrate. In some embodiments, the detection component is a sensor or a probe.

In other embodiments, both the first adjustment part 311 and the second adjustment part 321 may also be designed as motor lead screws, and both the first adjustment part 311 and the second adjustment part 321 are disposed in the vacuum chamber. The first adjustment part 311 and the second adjustment part 321 are both communicatively connected to the detection component, thereby facilitating the first adjustment part 311 and the second adjustment part 321 to automatically adjust the magnetic blocks at the corresponding positions along the radial direction of the target material 1 according to the detection results of the detection component. There is no need to break the vacuum of the vacuum chamber, making the adjustment operation more convenient and intelligent.

### Embodiment 3

This embodiment also provides a sputtering device, which includes a vacuum chamber, a coating substrates, and the above-mentioned sputtering cathode device. Both the coating substrate and the sputtering cathode device are disposed in the vacuum chamber, and the magnetic field lines generated by the magnetron assembly 2 can enable the atoms sputtered from the target material 1 to deposit onto the coating substrate. By applying the above-mentioned sputtering cathode device, the sputtering device provided in this embodiment achieves uniform etching of the target material, improves the utilization rate of the target material, eliminates the need for additional anode assemblies, reduces costs, and increases product yield.

## Claims

1. A magnetron sputtering-based adjustment method, comprising:
obtaining the film thickness distribution of a coating substrate on which a target material (1) is coated;
judging which one of a first side track (210) and a second side track (220) is a plasma-enhanced side track and which one is a non-plasma-enhanced side track according to the film thickness distribution of the coating substrate; wherein the first side track (210) and the second side track (220) are respectively two oppositely arranged side tracks obtained by dividing a linear region of an etching track (200) on the surface of the target material (1);
integrally reducing the magnetic field intensity of the plasma-enhanced side track.

2. The magnetron sputtering-based adjustment method according to claim 1, after integrally reducing the magnetic field intensity of the plasma-enhanced side track, the method further comprises:
reducing the magnetic field intensity of the first side track (210) and the second side track (220), wherein the reduction amount of the magnetic field intensity gradually decreases along the direction of drift current on the etching track (200); or,
increasing the magnetic field intensity of the first side track (210) and the second side track (220), wherein the increase amount of the magnetic field intensity gradually decreases along the reverse direction of the drift current on the etching track (200).

3. The magnetron sputtering-based adjustment method according to claim 2, after reducing the magnetic field intensity of the first side track (210) and the second side track (220), or increasing the magnetic field intensity of the first side track (210) and the second side track (220), the method further comprises:
after completing a coating process, acquiring morphology information of the target material (1) in a vacuum chamber;
stopping adjusting the magnetic field intensity in response to the morphology information of the target material (1) meeting preset requirements; or, returning to execute the step of integrally reducing the magnetic field intensity of the plasma-enhanced side track in response to the morphology information of the target material (1) not meeting the preset requirements.

4. The magnetron sputtering-based adjustment method according to claim 3, wherein acquiring the morphology information of the target material (1) in the vacuum chamber comprises:
acquiring radial dimensions of a plurality of collection points arranged axially on the target material (1).

5. The magnetron sputtering-based adjustment method according to any one of claims 2 to 4, further comprising:
when a plurality of the target materials (1) are arranged at intervals in the vacuum chamber, sequentially judging the plasma-enhanced side track and the non-plasma-enhanced side track on each target material (1), and sequentially integrally reducing the magnetic field intensity of the plasma-enhanced side track on each target material (1).

6. A sputtering cathode device, which adopts the magnetron sputtering-based adjustment method according to any one of claims 1 to 5 to adjust the magnetic field intensity at each position of the etching track (200) on the surface of the target material (1), the sputtering cathode device comprising:
a target material (1), the target material (1) being rotatably arranged in a vacuum chamber;
a magnetron assembly (2), arranged inside the target material (1); and
a adjustment assembly (3), arranged inside the target material (1) and having an end connected to the magnetron assembly (2), the adjustment assembly (3) being configured to adjust the magnetic field intensity at each position of the etching track (200) on the surface of the target material (1) according to the film thickness distribution of the coating substrate.

7. The sputtering cathode device according to claim 6, wherein the magnetron assembly (2) comprises a first yoke (21), a first magnet array (22), a second yoke (23), and a second magnet array (24), the first yoke (21) and the second yoke (23) are both arranged inside the target material (1), the first magnet array (22) is arranged on the first yoke (21), the second magnet array (24) is arranged on the second yoke (23), the first magnet array (22) and the second magnet array (24) are arranged adjacently, and both the first magnet array (22) and the second magnet array (24) extend along the axial direction of the target material (1);
the adjustment assembly (3) comprises a first adjustment component (31) and a second adjustment component (32), the first adjustment component (31) is configured to adjust the distance between each position along the extension direction of the first magnet array (22) and the target material (1), and the second adjustment component (32) is configured to adjust the distance between each position along the extension direction of the second magnet array (24) and the target material (1).

8. The sputtering cathode device according to claim 7, wherein the first adjustment component (31) comprises a plurality of first adjustment parts (311) arranged at intervals along the axial direction of the target material (1), an output end of each first adjustment part (311) is connected to the first yoke (21), and the output end of the first adjustment part (311) is configured to reciprocate along the radial direction of the target material (1) to drive a part of the first yoke (21) connected to the output end of the first adjustment part (311) to approach or move away from the target material (1); the second adjustment component (32) comprises a plurality of second adjustment part (321) arranged at intervals along the axial direction of the target material (1), an output end of each second adjustment part (321) is connected to the second yoke (23), and the output end of the second adjustment part (321) is configured to reciprocate along the radial direction of the target material (1) to drive a part of the second yoke (23) connected to the output end of the second adjustment part (321) to approach or move away from the target material (1).

9. The sputtering cathode device according to claim 8, wherein the magnetron assembly (2) further comprises a cooling pipe (25), the first yoke (21) and the second yoke (23) are both located on one side of the cooling pipe (25), the first adjustment part (311) is a first adjusting bolt, the first adjusting bolt is threadedly connected to the cooling pipe (25), and the first adjusting bolt is screwed through the cooling pipe (25) to connect with the first yoke (21);
the second adjustment part (321) is a second adjusting bolt, the second adjusting bolt is threadedly connected to the cooling pipe (25), and the second adjusting bolt is screwed through the cooling pipe (25) to connect with the second yoke (23).

10. A sputtering device, comprising a vacuum chamber, a coating substrate, and the sputtering cathode device according to any one of claims 6 to 9, the coating substrate and the sputtering cathode device are both arranged in the vacuum chamber, and magnetic field lines generated by the magnetron assembly (2) promote deposition of atoms sputtered from the target material (1) onto the coating substrate.
